Europäisches Patentamt

European Patent Office

Office européen des brevets

(19)

(11) **EP 0 938 716 B1**

(12) **EUROPÄISCHE PATENTSCHRIFT**

(45) Veröffentlichungstag und Bekanntmachung des Hinweises auf die Patenterteilung:
**16.04.2003 Patentblatt 2003/16**

(21) Anmeldenummer: **97949875.5**

(22) Anmeldetag: **06.11.1997**

(51) Int Cl.[7]: **G06F 17/60**

(86) Internationale Anmeldenummer:
**PCT/DE97/02588**

(87) Internationale Veröffentlichungsnummer:
**WO 98/022896 (28.05.1998 Gazette 1998/21)**

(54) **RECHNERGESTÜTZTES VERFAHREN ZUR PARTITIONIERUNG EINER ELEKTRISCHEN SCHALTUNG**

COMPUTER ASSISTED METHOD OF PARTITIONING AN ELECTRICAL CIRCUIT

PROCEDE ASSISTE PAR ORDINATEUR POUR LE PARTITIONNEMENT D'UN CIRCUIT ELECTRIQUE

(84) Benannte Vertragsstaaten:
**DE FR GB IT**

(30) Priorität: **18.11.1996 DE 19647620**

(43) Veröffentlichungstag der Anmeldung:
**01.09.1999 Patentblatt 1999/35**

(73) Patentinhaber: **Infineon Technologies AG
81669 München (DE)**

(72) Erfinder:
- **WEVER, Utz
  D-81539 München (DE)**
- **ZHENG, Qinghua
  D-82024 Taufkirchen (DE)**
- **FRÖHLICH, Norbert
  D-86157 Augsburg (DE)**

(74) Vertreter: **Reinhard - Skuhra - Weise & Partner
Postfach 44 01 51
80750 München (DE)**

(56) Entgegenhaltungen:
- **B. RIESS ET AL: "Partitioning Very Large Circuits Using Analytical Placement Techniques" PROCEEDINGS OF THE 31ST ACM/IEEE DESIGN AUTOMATION CONFERENCE, 6.Juni 1994, Seiten 646-651, XP000489051 in der Anmeldung erwähnt**
- **T. KAGE ET AL: "A Circuit Partitioning Approach for Parallel Circuit Simulation" IEICE TRANSACTIONS ON FUNDAMENTALS OF ELECTRONICS, COMMUNICATIONS AND COMPUTER SCIENCES, Bd. E77-A, Nr. 3, März 1994, TOKYO, JP, Seiten 461-465, XP000450882**
- **G.-G. HUNG ET AL: "Improving the Performance of Parallel Relaxation-Based Circuit Simulators" IEEE TRANSACTIONS ON COMPUTER-AIDED DESIGN OF INTEGRATED CIRCUITS AND SYSTEMS, Bd. 12, Nr. 11, November 1993, NEW YORK, US, Seiten 1762-1774, XP000450933**
- **J. LI ET AL: "New Spectral Linear Placement and Clustering Approach" 33RD DESIGN AUTOMATION CONFERENCE, 3. - 7.Juli 1996, LAS VEGAS, NV, US, Seiten 88-93, XP002058127 in der Anmeldung erwähnt**

## Beschreibung

Bei der Schaltungssimulation sehr großer Schaltungen, d.h. von Schaltungen mit einer sehr großen Anzahl von Elementen ist eine serielle Bearbeitung, d.h. Ermittlung der Schaltungsgrößen durch einen Rechner sehr zeitaufwendig. Selbst Vektorrechner, die in ihrem Betrieb sehr teuer sind, benötigen einen immensen Bedarf an Rechenkapazität und an Zeit zur Ermittlung der elektrischen Beschreibungsgrößen für eine Schaltung, die einige 100.000 Transistoren aufweist.

Zur Vermeidung der seriellen Durchführung einer Schaltungssimulation kann aus diesem Grunde die elektrische Schaltung in mehrere Teile aufgeteilt werden, die dann jeweils von verschiedenen Rechnern bzw. Prozessoren bearbeitet werden, was zu einer parallelen Durchführung der Schaltungssimulation führt.

IEICE TRANSACTIONS ON FUNDAMENTALS OF ELECTRONICS, COMMUNICATIONS AND COMPUTER SCIENCES,

T. Kage et al.: "A circuit partitioning approach for parallel circuit simulation" Bd. E77-A, Nr.3, März 1994, Tokyo, JP, Seiten 461-465, XP 000450882 zeigt beispielsweise ein Verfahren zur Partitionierung von elektrischen Schaltungen welches aus folgenden Schritten besteht:

a) Das Gruppieren von Transistoren, Kondensatoren und Widerständen in sog. Transistorgruppen.
b) Das Zusammenfassen von mehreren Transistorgruppen in sog. Schaltungsblocks.
c) Minimieren von Verbindungen zwischen den Schaltungsblöcken durch Verschieben von Transistorgruppen.
d) Nivellierung der Anzahl der Transistorgruppen in den Schaltungsblöcken.

Um jedoch eine möglichst gute Parallelisierbarkeit der Ermittlung der elektrischen Beschreibungsgrößen für die Eiektroschaltung zu erreichen, ist es sehr vorteilhaft, folgende zwei Kriterien bei der Partitionierung der elektrischen Schaltung in mehrere Teile zu beachten. Es ist von erheblicher Bedeutung, daß alle gebildeten Partitionen der elektrischen Schaltung möglichst gleich groß sind, um dadurch den durch die Parallelisierung erzielbaren Effekt zu verstärken. Ist eine Partition um Größenordnungen größer als die restlichen Partitionen, so ist die Bearbeitung der wesentlich größeren Partition wiederum sehr viel rechenaufwendiger als die Bearbeitung der restlichen Partitionen. Ferner ist es bei der Partitionierung wichtig, daß zwischen den einzelnen Partitionen möglichst nur eine geringe Anzahl von Verbindungen besteht, da bei den bekannten Verfahren zur "parellelisierten" Schaltungssimulation die benötigte Übertragungskapazität, d.h. die erforderliche Kommunikation zwischen den Rechnern bzw. Prozessoren, die jeweils eine Partition bearbeiten, erheblich steigt mit steigender Anzahl von bestehenden Verbindungen zwischen den Partitionen.

Eine Sprache zur textuellen Beschreibung einer elektrischen Schaltung, welche durch einen Rechner verarbeitet werden kann, ist aus dem Dokument [1] als Schaltungssimulationssprache SPICE bekannt.

In den Dokumenten [2] und [3] ist beschrieben, wie eine parallelisierte Schaltungssimulation durchgeführt werden kann, vorausgesetzt, es liegt eine beliebige Anzahl von Partitionen der elektrischen Schaltung vor. Die Art und Weise, wie Partitionen ermittelt werden können, wird in diesen Dokumenten nicht beschrieben.

Aus den Dokumenten [4] und [7] ist ein globales Partitionierungsverfahren auf der sogenannten Logikebene, welche auch als Gatterebene bezeichnet wird, bekannt.

Auf der Logikebene werden diskrete Ereignisse beschrieben, mit denen jedoch keine stetigen dynamischen Eigenschaften einer elektrischen Schaltung auf der sogenannten Transistorebene, also auf der eigentlich physikalischen Ebene der elektrischen Schaltung beschrieben werden können.

Somit sind die Ergebnisse einer Schaltungssimulation, die auf Logikebene erfolgt, für einige Anwendungen unsicher und ungenau, da auch ein genauer Zeitverlauf der elektrischen Signale, der in der elektrischen Schaltung auftritt, nicht berücksichtigt werden kann.

Ferner ist eine modellhafte Beschreibung der einzelnen Gatter für die Schaltungssimulation auf Gatterebene erforderlich, wobei zur Simulation auf Tranisistorebene die Schaltungsbeschreibung mit Transistormodellen bereits vorliegt. Die modellhafte Beschreibung muß ermittelt werden, bevor das Verfahren auf Gatterebene durchgeführt werden kann.

Die sogenannte Konjugations-Gradienten-Methode ist aus dem Dokument [5] bekannt.

Eine Übersicht über verschiedene Partitionierungsvorschriften ist in [8] zu finden.

Somit liegt dem Verfahren das Problem zugrunde, ein Verfahren zur Partitionierung einer elektrischen Schaltung anzugeben, welches direkt die Elemente der elektrischen Schaltung auf Transistorebene berücksichtigt.

Das Problem wird durch das Verfahren gemäß Patentanspruch 1 gelöst.

Bei dem Verfahren wird die elektrische Schaltung auf einen Graphen abgebildet, der die gleiche Topologie wie die elektrische Schaltung aufweist. Die Kanten und/oder Knoten des Graphen werden mit Gewichtswerten gewichtet, die einen ungefähr erforderlichen Rechenaufwand zur Ermittlung elektrischer Beschreibungsgrößen für das jeweils durch die Kante und/oder Knoten repräsentierte Element der elektrischen Schaltung beschreiben.

Die Partitionen für die elektrische Schaltung in dem Graphen werden in einer Weise gebildet, daß auf die Elemente der elektrischen Schaltung ein Verfahren zur Plazierung der Elemente angewendet wird, bei dem eine Gesamtlänge von Kopplungen zwischen den Elementen in der elektrischen Schaltung minimiert wird. Für die elektrische Schaltung wird ferner ein Maß für eine Anzahl entstehender Randknoten und/oder geschnittener Kanten von Partitionen ermittelt, die bei der Partitionierung jeweils entstehen würden. Abhängig von dem Maß werden die Partitionen gebildet, indem die Elemente in die einzelnen Partitionen gruppiert werden.

Das Verfahren weist einige erhebliche Vorteile gegenüber dem aus dem Dokument [4] bekannten Verfahren auf.

Da das Verfahren direkt auf der Transistorebene der elektrischen Schaltung arbeitet, sind die durch das Verfahren erzielten Ergebnisse bei einer späteren Schaltungssimulation unter Verwendung der auf die erfindungsgemäß ermittelten Partitionen erheblich genauer und verläßlicher.

Vorteilhafte Weiterbildungen der Erfindung ergeben sich aus den abhängigen Ansprüchen.

Es ist vorteilhaft, für vorgebbare Elemente der elektrischen Schaltung zu Beginn des Verfahrens festzulegen, daß die Elemente gemeinsam in eine Partition gruppiert werden. Durch diese Weiterbildung des Verfahrens wird es möglich sicherzustellen, daß beispielsweise bei gesteuerten Quellen sowohl die steuernden Elemente als auch die gesteuerte Quelle gemeinsam in einer Partition bearbeitet werden können. Ebenso ist es durch diese Weiterbildung möglich, Verbindungsschleifen in der elektrischen Schaltung, die durch Hintereinanderschalten von spanungsdefinierenden Elementen wie z. B. Spannungsquellen und Induktivitäten entstehen, ebenso gemeinsam in einer Partition anzuordnen. Ferner wird es durch diese Vorgehensweise möglich, möglicherweise durch die Partitionierung und die Modellierung der Schnittstellen entstehende Kurzschlüsse zu vermeiden.

Durch die Weiterbildung des Verfahrens, daß mehreren Kanten und/oder Knoten des Graphen ein gemeinsamer Gewichtswert zugeordnet wird, wird die Durchführung des Verfahrens durch einen Rechner weiter beschleunigt, da bei dieser Weiterbildung eine geringere Anzahl von Gewichtswerten im Rahmen des Verfahrens berücksichtigt werden müssen.

Ferner ist es vorteilhaft, mehrere Partitionen für die elektrische Schaltung zu bilden, für die Partitionen die entsprechenden Graphen der Partitionen wieder auf die elektrische Schaltung abzubilden und die entstehenden Partitionen der elektrischen Schaltung parallel auf verschiedenen Rechnern bzw. Prozessoren zu verarbeiten. Durch diese Parallelisierung wird eine Schaltungssimulation einer sehr großen Schaltung erheblich schneller durchführbar, als es bei einer rein "seriellen" Schaltungssimulation möglich ist.

Ferner ist es vorteilhaft, bei der parallelisierten Schaltungssimulation die Verarbeitung der einzelnen Partitionen zentral zu steuern. Auf diese Weise wird eine geregelte Schaltungssimulation mit möglichst geringem Kommunikationsaufwand realisiert.

Ferner ist es vorteilhaft, den einzelnen Anschlüssen der Partitionen, die mit Komponenten, die nicht in der Partition liegen, gekoppelt sind, zusätzlich mit einer Spannungsquelle und einem Wiederstand zu versehen, wobei der Spannungsquelle jeweils von einer zentralen Steuereinheit, die die parallelisierte Bearbeitung der Partitionen steuert, die elektrischen Randbeschreibungsgrößen zugewiesen werden. Durch den Widerstand, der jeweils in den Anschlüssen vorgesehen ist, wird die Konvergenz der Schaltungssimulation während der parallelisierten Schaltungssimulation gewährleistet, deren Wert durch die Steuereinheit dynamisch angepaßt wird.

In den Figuren ist ein Ausführungsbeispiel des Verfahrens dargestellt, welches im weiteren näher erläutert wird.

Es zeigen

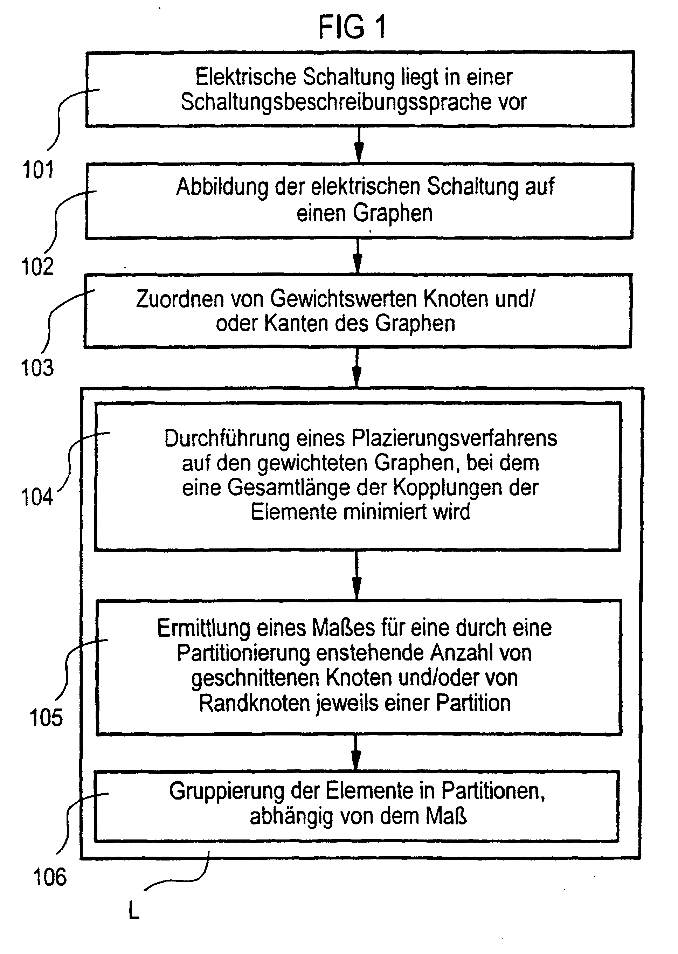

Fig. 1 ein Ablaufdiagramm, in dem die einzelnen Verfahrensschritte des Verfahrens dargestellt sind;

Fig. 2 ein Skizze, in der verschiedene Weiterbildungen des Verfahrens dargestellt sind;

Elektrische Schaltungen, die eine sehr große Anzahl von Elementen aufweisen, können durch Aufteilung der Elemente, d.h. Partitionierung der Elemente in eine beliebige Anzahl von Partitionen und eine Bearbeitung der einzelnen Partitionen auf verschiedenen Rechnern bzw. Prozessoren, die eine Schaltungssimulation durchführen, parallelisiert werden. Damit kann die Durchführung der gesamten Schaltungssimulation erheblich beschleunigt werden.

Damit jedoch die Parallelisierung möglichst optimal ausgestaltet ist, müssen die einzelnen Partitionen sorgfältig bestimmt werden.

Dabei ist es wichtig, zum einen auf eine ungefähr einheitliche Größe der Partition zu achten und zum anderen darauf zu achten, daß die einzelnen Partitionen keine zu große Anzahl von Anschlüssen "nach außen", beispielsweise Kopplungen mit mit anderen, nicht in der Partition liegenden Elementen aufweisen.

Elektrische Schaltungen liegen zur Bearbeitung im Rahmen einer Schaltungssimulation durch einen Rechner üblicherweise in einer Schaltungsbeschreibungssprache vor 101, beispielsweise in der sog. Sprache SPICE, welche in dem Dokument [1] beschrieben ist.

Das Verfahren ist jedoch in keinster Weise auf eine Beschreibung der elektrischen Schaltung in einer Schaltungsbeschreibungssprache und ebenso wenig auf die Verwendung der speziellen Schaltungsbeschreibungssprache SPICE beschränkt.

In einem ersten Verfahrensschritt 102 wird die elektrische Schaltung auf einem Graphen abgebildet, der die gleiche Topologie aufweist wie die elektrische Schaltung. Dies erfolgt beispielsweise ausgehend von der in der Schaltungsbeschreibungssprache SPICE vorliegenden elektrischen Schaltung. Der Graph weist entsprechend der Topologie der elektrischen Schaltung die entsprechenden Knoten auf. Die einzelnen Elemente der elektrischen Schaltung werden durch Knocen des Graphen repräsentiert.

Je nach Interpretation des Graphen ist es jedoch ebenso moglich, die einzelnen Elemente der elektrischen Schaltung auf Kanten zwischen den Knoten des Graphen abzubilden.

In einer Weiterbildung des Verfahrens ist es vorteilhaft, zu Beginn des Verfahrens einzelne Elemente der elektrischen Schaltung zu markieren, d.h. für die entsprechenden markierten Elemente festzulegen, daß die markierten Elemente im weiteren Verfahren jeweils gemeinsam einer Partition zugeordnet werden. Es können verschiedene Markierungen verschiedene Elemente zu unterschiedlichen Partitionen zuweisen. Es ist auch vorgesehen, Elemente lediglich in einer Weise zu markieren, die derart von dem Rechner, der das Verfahren durchführt, interpretiert wird, daß die jeweils paarweisen Elemente einer Partition zugeordnet werden.

Dabei ist es vorteilhaft, beispielsweise folgende Spezialfälle einer elektrischen Schaltung zu berücksichtigen. Enthält eine elektrische Schaltung gesteuerte Quellen, beispielsweise gesteuerte Stromquellen oder gesteuerte Spannungsquellen, so ist es vorteilhaft, daß sowohl die steuernden Elemente als auch die gesteuerte Quelle für die spätere Schaltungssimulation gemeinsam in einer Partition enthalten sind.

Ferner ist es vorteilhaft, gekoppelte Induktivitäten ebenso jeweils einer gemeinsamen Partition zuzuordnen. Auch ist es wichtig, in einer Weiterbildung des Verfahrens zu berücksichtigen, daß durch die Partitionierung und deren algorithmische Verarbeitung mittels eines Rechners keinerlei Kurzschlüsse auftreten dürfen.

In einem weiteren Schritt 103 werden den Knoten bzw. je nach Interpretation des Graphen den Kanten Gewichtswerte G zugeordnet. Mit den Gewichtswerten G wird beschrieben, welcher Rechenaufwand ungefähr zur Ermittlung von elektrischen Beschreibungsgrößen für das jeweilige Element der elektrischen Schaltung, welches durch den Knoten bzw. die Kante repräsentiert wird, der der Gewichtswert G jeweils zugewiesen wird, zu erwarten ist.

Ein Maß für den benötigten Rechenaufwand ist beispielsweise in der Anzahl der Codezeilen zu sehen, der zur Ermittlung der elektrischen Beschreibungsgrößen für das jeweils spezifische Element im Rahmen der Schaltungssimulation benötigt wird. Als groben Maßstab ist hier anzumerken, daß die Ermittlung der elektrischen Beschreibungsgrößen für Transistoren erheblich größer ist als der Aufwand zur Ermittlung der elektrischen Beschreibungsgrößen für einen elektrischen Widerstand oder auch für eine Kapazität. Die Wahl der Gewichtswerte G ist jedoch äußerst unkritisch und stellt lediglich ein ungefähres Größenverhältnis des benötigten Rechenaufwandes dar. Es ist sogar ausreichend, beispielsweise einem Knoten bzw. einer Kante, die einen Transistor repräsentiert, einen hohen Gewichtswert G, z. B. den Gewichtswert G = 300 zuzuordnen und den Knoten bzw. den Kanten, die einen Widerstand oder eine Kapazität repräsentieren, einen kleinen Gewichtswert, beispielsweise einen Gewichtswert G = 1 ode sogar einen Gewichtswert G = 0.

Unter elektrischen Beschreibungsgrößen sind in diesem Zusammenhang z. B. die entsprechenden Ströme und Spannungen eines Elementes der elektrischen Schaltung zu verstehen.

In einem weiteren Schritt 104 wird auf den gewichteten Graphen und somit auf die Elemente der elektrischen Schaltung ein Plazierungsverfahren durchgeführt. Mit dem Plazierungsverfahren wird eine Gesamtlänge von Kopplungen von Elementen der elektrischen Schaltung minimiert.

Dies kann allgemein mit jedem beliebigen Plazierungsverfahren erfolgen. Beispielsweise kann dies auch mit den Plazierungsverfahren, die in dem Dokument [4] beschrieben sind, erfolgen.

Im weiteren werden zwei Möglichkeiten zur Verwendung der Plazierungsverfahren im Rahmen der Partitionierung von Elementen der elektrischen Schaltung auf Transistorebene näher erläutert.

In einem ersten vorteilhaft verwendbaren Plazierungsverfahren wird eine lineare Zielfunktion der folgenden Form verwendet:

$$\min_{\underline{x} \in \mathfrak{R}^n} \sum_{i=1}^{n} \sum_{j=1}^{n} a_{ij} \left| \underline{x}_i - \underline{x}_j \right| \tag{1}$$

mit

$$\sum_{i=1}^{n} \underline{x}_i = f \qquad\qquad (2).$$

Mit $a_{ij}$ werden Elemente einer Adjazenzmatrix $\underline{A}$ bezeichnet, die eine Dimension n x n aufweist. Dabei wird mit n die Anzahl der berücksichtigten Elemente der elektrischen Schaltung bezeichnet. Die Matrixelemente $a_{ij}$ der Adjazenzmatrix $\underline{A}$ werden beispielsweise durch Summierung aller Kanten des gewichteten Graphen, mit denen ein Element i mit einem weiteren Element j gekoppelt ist, gebildet. Mit $\underline{x}_i$ und $\underline{x}_j$ wird jeweils ein Datenvektor bezeichnet, mit dem die örtliche Position des jeweiligen Elements i bzw. j der elektrischen Schaltung innerhalb der elektrischen Schaltung bezeichnet wird. Mit f wird eine vorgebbare lineare Beschränkungsgröße bezeichnet.

Aus den Gleichungen (1) und (2) ist erkennbar, daß es sich um ein Problem der linearen Programmierung handelt, welches jedoch unter Verwendung der Substitution:

$$g_{ij} = \frac{a_{ij}}{|\underline{x}_i - \underline{x}_j|} \qquad\qquad (3)$$

in ein Problem der quadratischen Programmierung umformuliert werden kann.

Dieses Problem kann sehr effizient mit der sog. Konjugations-Gradienten-Methode gelöst werden. Die Konjugations-Gradienten-Methode ist aus dem Dokument [5] bekannt.

Es kann im Rahmen dieses Verfahrens sowohl eine eindimensionale Plazierung als auch eine mehrdimensionale Plazierung bestimmt werden.

Je besser die Qualität der ermittelten Plazierung ist, desto geringer ist auch die erforderliche Gesamtlänge der Kopplungen zwischen den Elementen der elektrischen Schaltung, um die Elemente miteinander zu koppeln. Dies resultiert daraus, daß durch die Plazierungsverfahren im Rahmen der Zielfunktion die Gesamtlänge der Kopplungen der Elemente der elektrischen Schaltung minimiert wird.

Durch Reduktion der benötigten Gesamtlänge der Kopplungen der Elemente wird die Anzahl von Kopplungen zwischen Partitionierungen bei einer im weiteren durchgeführten Partitionierung der elektrischen Schaltung verringert.

Da in dem Spezialfall der in dem Dokument [5] beschriebenen Konjugations-Gradienten-Methode mindestens eine Zelle einer festen Position zugeordnet werden muß, ist es in einer Weiterbildung des Verfahrens vorteilhaft, jeweils das ganz links am Rand und ganz rechts am Rand der elektrischen Schaltung sich befindende Element auf eine feste Position zu setzen.

Damit sind die Ortskoordinaten und somit die Ortsvektoren dieser Elemente festgelegt und die Konjugations-Gradienten-Methode wird durchgeführt.

In einem weiteren Schritt 105 wird für die Elemente der elektrischen Schaltung für jedes Element bzw. für jedes Paar von Elementen, die miteinander gekoppelt sind, ein Maß für eine durch eine mögliche Partitionierung entstehende Anzahl von geschnittenen Kanten bzw. bei anderer Interpretation des Graphen G entstehende Anzahl von Randknoten jeweils einer Partition ermittelt. Dies erfolgt beispielsweise unter Verwendung des sog. Rational Cut Measures RC. Das Rational Cut Measure RC kann beispielsweise nach folgender Vorschrift gebildet werden:

$$RC = \frac{C_{LR}}{|L| \cdot |R|} \qquad\qquad (4),$$

wobei mit

- RC das Maß für die Anzahl entstehender Randknoten bezeichnet wird,
- L eine erste Partition bezeichnet wird,
- R eine zweite Partition bezeichnet wird,
- $C_{LR}$ eine gewichtete Anzahl von Kopplungen der ersten Partition mit der zweiten Partition bezeichnet wird,
- |L| eine gewichtete Anzahl der Elemente bezeichnet wird, die die erste Partition enthält,
- |R| eine Anzahl der Elemente bezeichnet wird, die die zweite Partition enthält.

Details über die Art der Verwendung dieses Maßes im Rahmen des Verfahrens ist beispielsweise in dem Dokument [6] beschrieben.

Zur Bestimmung der Partitionen ist es vorgesehen, das Maß RC für jede mögliche Schnittstelle einer Partition innerhalb der elektrischen Schaltung zwischen den Elementen der elektrischen Schaltung zu ermitteln. Dies bedeutet, daß für alle Elemente der elektrischen Schaltung, die in unterschiedliche Partitionen gruppiert werden könnten, das Maß RC ermittelt wird. Zur Vereinfachung des Verfahrens ist es ebenso jedoch vorgesehen, das Maß RC nur für eine vorgebbare Anzahl von Elementen zu ermitteln.

Die Partitionierung erfolgt dann jeweils an den Stellen, an denen das Maß ein lokales Minimum aufweist. Details über die Vorgehensweise hierfür sind ebenso in dem Dokument [6] beschrieben.

Eine mögliche zweite Vorgehensweise zur Plazierung der Elemente und somit zur Bildung der Partitionen ist in dem Kapitel 3 des Dokuments [4] dargestellt.

Zu betonen ist jedoch, daß das in dem Dokument [4] und in allen weiteren Dokumenten beschriebene Plazierungsverfahren jeweils sich lediglich auf die Gatterebene der Beschreibung einer elektrischen Schaltung bezieht.

Unter Verwendung der ursprünglichen Beschreibung der elektrischen Schaltung, beispielsweise in der Schaltungsbeschreibungssprache SPICE wird die Partition in eine für den Rechner weiter zu verarbeitende Syntax, beispielsweise wiederum in die Schaltungsbeschreibungssprache SPICE abgebildet. Bei dieser Abbildung wird die Information der jeweiligen Partition für das jeweilige Element der elektrischen Schaltung beispielsweise durch Markierung des jeweiligen Elementes berücksichtigt.

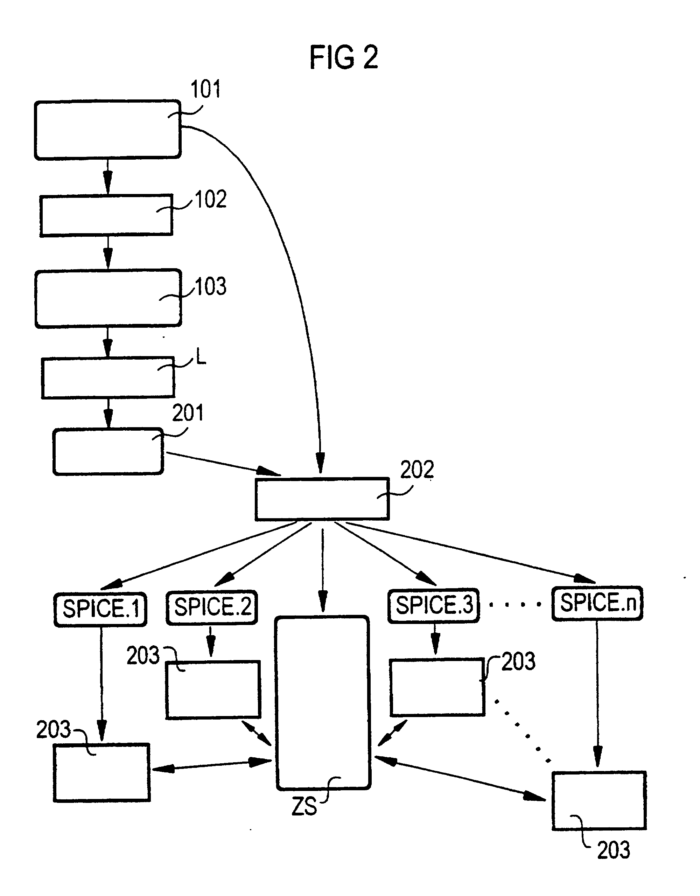

Durch diese Rückabbildung 201 (vgl. Figur 2) entsteht also wiederum für den Spezialfall der Verwendung der Schaltungsbeschreibungssprache SPICE eine Liste mit den Schaltungselementen der elektrischen Schaltung sowie mit den Kopplungen und der jeweiligen Angabe der Partition, der das jeweilige Element zugeordnet wurde.

In einer Weiterbildung des Verfahrens ist es vorteilhaft, dieses Verfahren für eine beliebige Zahl von Partitionen durchzuführen, d.h. die elektrische Schaltung wird in eine beliebige Anzahl von Partitionen unterteilt. Bei dieser Weiterbildung entstehen entsprechend der Anzahl gebildeter Partitionen partitionsspezifische Listen mit den Elementen der elektrischen Schaltung in der Schaltungsbeschreibungssprache SPICE 202. Eine in einer Weiterbildung des Verfahrens vorteilhafte Parallelisierung der Schaltungssimulation der elektrischen Schaltung wird nunmehr dadurch erreicht, daß die elektrischen Beschreibungsgrößen für die Elemente der elektrischen Schaltung für jede Partition separat ermittelt werden, wobei mindestens ein Teil der Partitionen parallel auf mehreren Rechnern und/oder Prozessoren bearbeitet werden kann. Dies entspricht einer Parallelisierung der Schaltungssimulation.

In einer Weiterbildung des Verfahrens ist es ferner vorgesehen, mehreren Knoten bzw. Kanten des Graphen G einen gemeinsamen Gewichtswert zuzuordnen. Durch diese Vorgehensweise wird der benötigte Rechenaufwand reduziert.

Verfahren zur parallelisierten Schaltungssimulation auf verteilten Prozessoren, bzw. verteilten Rechnern sind beispielsweise aus dem Dokument [2] und [3] bekannt. Diese können ohne Einschränkung auf die durch das Verfahren gebildeten Partitionen angewendet werden.

Ferner ist es in einer Weiterbildung des Verfahrens vorgesehen, die parallele Verarbeitung der Partitionen über eine zentrale Steuereinheit ZS zentral zu steuern. Dies bedeutet beispielsweise, daß die Kommunikation der einzelnen Partitionen in dem Verfahren der Schaltungssimulation, wie sie in den Dokumenten [2] und [3] beschrieben ist, d.h. die Übermittlung von Daten lediglich zwischen der zentralen Steuereinheit ZS und dem Teil der Partitionen erfolgt, der zentral gesteuert wird.

In Fig. 2 ist die parallelisierte Verarbeitung durch eine Vielzahl von SPICE-Dateien SPICE.1, SPICE.2, SPICE.3 bis SPICE.N symbolisch dargestellt. In diesen SPICE-Dateien sind die einzelnen Beschreibungen der Partitionen in der Schaltungsbeschreibungssprache SPICE enthalten.

Es wird für die jeweilige Partition eine Schaltungsimulation durchgeführt 203, beispielsweise zentral gesteuert von der zentralen Steuereinheit ZS.

Ferner ist es in einer Weiterbildung des Verfahrens vorgesehen, mindestens einen Teil der Anschlüsse der jeweiligen Partition, welche im Rahmen der parallelisierten Schaltungssimulation bearbeitet wird, zusätzlich eine Spannungsquelle zuzuweisen, welcher jeweils im Rahmen der bekannten Verfahren von der zentralen Steuereinheit ZS ein entsprechender Wert zugewiesen wird. Zur Gewährleistung der Konvergenz des iterativen Verfahrens aus dem Dokument [2] und [3] ist es vorteilhaft, zumindest bei einem Teil der Anschlüsse der jeweiligen Partitionen zusätzlich einen Widerstand vorzusehen, dessen Wert von der Steuereinheit ZS dynamisch angepaßt wird.

Im Rahmen dieses Dokumentes wurden folgende Veröffentlichungen zitiert:

[1] I. Hoefer, H. Nielinger, SPICE Analyseprogramm für elektronische Schaltungen, Springer Verlag, Berlin, B, ISBN 3-540-15160-5, S. 7 bis 22, 1985

[2] U. Wever, Q. Zheng et al, Domain Decomposition Methods for Circuit Simulation, Proceedings of the 8th Workshop on Parallel and Distributed Simulation, PADS 94 Edinburgh, Scotland, UK, ZS, S. 183-186, Juli 1994

[3] U. Wever & Q. Zheng, Parallel Transient Analysis for Circuit Simulation, Proceedings of the 29th Annual Hawaii International Conference on System Sciences, ZS, S. 442 bis 447, 1996

[4] B. Riess et al, Partitioning Very Large Circuits Using Analytical Placement Techniques, Proceedings of the 31st ACM/IEEE Design Aucmation Conference, S. 646 bis 651, 1994

[5] G. Sigl et al, Analytical Placement: A Linear or a Quadratic Objective Function?, Proceedings of the 28th ACM/IEEE DAC, S. 427 - 432, 1991

[6] L. Hagen und A. B. Kahng, Fast Spectral Methods for Ratio Cut Partitioning and Clustering, IEEE/ACM International Conference on Computer-Aided Design, S. 10 - 13, 1991

[7] Ch. Cheng et al, New Spectral Linear Placement and Clustering Approach, In: 33rd Design Automation Conference, 3. - 7. Juni, Las Vegas, S. 88 - 93, 1996

[8] F. Johannes, Partitioning of VLSI Circuits and Systems, 33rd Design Automation Conference, 3. - 7. Juni, Las Vegas, S. 83 - 87, 1996

**Patentansprüche**

1. Rechnergestütztes Verfahren zur Partitionierung einer elektrischen Schaltung,

   - bei dem die elektrische Schaltung auf einen Graphen abgebildet wird, der die gleiche Topologie aufweist wie die elektrische Schaltung,
   - bei dem Knoten und/oder Kanten des Graphen Gewichtswerte zugeordnet werden, mit denen ein erforderlicher Rechenaufwand zur Ermittlung von elektrischen Beschreibungsgrößen für Elemente der elektrischen Schaltung, die durch den jeweiligen Knoten und/oder durch die jeweilige Kante repräsentiert werden, beschrieben wird,
   - bei dem auf die Elemente ein Verfahren zur Plazierung der Elemente der elektrischen Schaltung angewendet wird,
   - bei dem bei dem Verfahren zur Plazierung der Elemente eine Gesamtlänge von Kopplungen zwischen den Elementen minimiert wird, wobei die den Knoten und/oder Kanten zugeordneten Gewichtswerte berücksichtigt werden,
   - bei dem für die elektrische Schaltung ein Maß für eine Anzahl entstehender geschnittener Kanten und/oder entstehender Randknoten von Partitionen der elektrischen Schaltung bei der Partitionierung, ermittelt wird, und
   - bei dem abhängig von dem Maß die Elemente in Partitionen gruppiert werden.

2. Verfahren nach Anspruch 1,
   bei dem zu Beginn des Verfahrens eine Gruppierung von Elementen der elektrischen Schaltung durchgeführt wird, für die jeweils festgelegt wird, daß diese Elemente gemeinsam einer Partition zugeordnet werden.

3. Verfahren nach Anspruch 2,
   bei dem bei der Gruppierung der Elemente der elektrischen Schaltung mindestens eine der folgenden Vorschriften angewendet wird:

   - Elemente einer gesteuerten Quelle, mindestens ein steuerndes Element und die gesteuerte Quelle, werden in gemeinsam einer Partition zugeordnet,
   - Verbindungsschleifen in der elektrischen Schaltung, die werden gemeinsam einer Partition zugeordnet,
   - es dürfen keine Kurzschlüsse durch die Partitionierung und/oder durch eine Modellierung einer Schnittstelle entstehen.

4. Verfahren nach einem der Ansprüche 1 bis 3,
   bei dem mehreren Knoten und/oder Kanten des Graphen ein gemeinsamer Gewichtswert zugeordnet wird.

5. Verfahren nach einem der Ansprüche 1 bis 4,
   bei dem der Graph der Partition abgebildet wird auf die elektrische Schaltung, wobei die Partition die Elemente der elektrischen Schaltung aufweist entsprechend der durchgeführten Partitionierung.

6. Verfahren nach einem der Ansprüche 1 bis 5,

- bei dem mehrere Partitionen durch mehrfache Durchführung des Verfahrens gebildet werden, und
- bei dem die elektrischen Beschreibungsgrößen für die Elemente der elektrischen Schaltung für jede Partition ermittelt werden, wobei mindestens ein Teil der Partitionen parallel auf mehreren Rechnern und/oder Prozessoren bearbeitet wird.

**7.** Verfahren nach Anspruch 6,
bei dem die parallele Verarbeitung der Partitionen zentral gesteuert wird.

**8.** Verfahren nach Anspruch 7,
bei dem mindestens ein Teil der Partitionen in einer Weise zentral gesteuert werden, daß alle Anschlüsse der jeweiligen Partition nur mit einer zentralen Steuereinheit gekoppelt sind und somit eine Übermittlung von Daten nur zwischen der zentralen Steuereinheit und mindestens dem Teil der Partitionen erfolgt.

**9.** Verfahren nach Anspruch 8,
bei dem mindestens einem Teil der Anschlüsse der jeweiligen Partition zusätzlich eine Spannungsquelle zugewiesen wird, deren Wert während der Ermittlung der elektrischen Beschreibungsgrößen von der zentralen Steuereinheit vorgegeben wird.

**10.** Verfahren nach Anspruch 9,
bei dem mindestens einem Teil der Anschlüsse der jeweiligen Partition zusätzlich ein Widerstand zugewiesen wird.

**11.** Verfahren nach einem der Ansprüche 1 bis 10,
bei dem das Maß für die Anzahl entstehender geschnittener Kanten und/oder entstehender Randknoten jeweils nach der folgenden Vorschrift gebildet wird:

$$RC = \frac{C_{LR}}{|L| \cdot |R|},$$

wobei mit

- RC das Maß für die Anzahl entstehender geschnittener Kanten und/oder entstehender Randknoten bezeichnet wird,
- L eine erste Partition bezeichnet wird,
- R eine zweite Partition bezeichnet wird,
- $C_{LR}$ eine Anzahl von Kopplungen der ersten Partition mit der zweiten Partition bezeichnet wird,
- |L| eine gewichtete Anzahl der Elemente bezeichnet wird, die die erste Partition enthält,
- |R| eine gewichtete Anzahl der Elemente bezeichnet wird, die die zweite Partition enthält.

**Claims**

**1.** Computer-aided method for partitioning an electrical circuit,

- in which the electrical circuit is mapped onto a graph which has the same topology as the electrical circuit,
- in which nodes and/or edges on the graph are assigned weight values which are used to describe a necessary computation complexity for ascertaining electrical descriptive variables for elements of the electrical circuit which are represented by the respective node and/or by the respective edge,
- in which a method for placing the elements of the electrical circuit is applied to the elements,
- in which the method for placing the elements involves minimization of an overall length for couplings between the elements, with the weight values associated with the nodes and/or edges being taken into account,
- in which a measure of a number of cut edges arising and/or edge nodes arising for partitions of the electrical circuit during partitioning is ascertained for the electrical circuit, and
- in which the elements are grouped into partitions on the basis of the measure.

**2.** Method according to claim 1,
in which the start of the method involves grouping elements of the electrical circuit for which it is respectively stipulated that these elements be assigned to a partition together.

**3.** Method according to claim 2,
in which grouping the elements of the electrical circuit involves at least one of the following rules being applied:

- elements of a controlled source, at least one controlling element and the controlled source are assigned to a partition in [sic] together,
- connecting loops in the electrical circuit are assigned to a partition together,
- no short circuits must be produced as a result of the partitioning and/or as a result of modeling of an interface.

**4.** Method according to one of claims 1 to 3,
in which a plurality of nodes and/or edges on the graph are assigned a common weight value.

**5.** Method according to one of claims 1 to 4,
in which the graph of the partition is mapped onto the electrical circuit, the partition containing the elements of the electrical circuit in line with the partitioning carried out.

**6.** Method according to one of claims 1 to 5,

- in which a plurality of partitions are formed by repeatedly carrying out the method, and
- in which the electrical descriptive variables for the elements of the electrical circuit are ascertained for each partition, at least some of the partitions being processed in parallel on a plurality of computers and/or processors.

**7.** Method according to claim 6,
in which the parallel processing of the partitions is controlled centrally.

**8.** Method according to claim 7,
in which at least some of the partitions are controlled centrally such that all the connections in the respective partition are coupled only to a central control unit, and hence data are transmitted only between the central control unit and at least some of the partitions.

**9.** Method according to claim 8,
in which at least some of the connections in the respective partition are additionally assigned a voltage source whose value is prescribed by the central control unit while the electrical descriptive variables are ascertained.

**10.** Method according to claim 9,
in which at least some of the connections in the respective partition are additionally assigned a resistor.

**11.** Method according to one of claims 1 to 10,
in which the measure of the number of cut edges arising and/or edge nodes arising is respectively formed on the basis of the following rule:

$$RC = \frac{C_{LR}}{|L|\,|R|},$$

, where

- RC denotes the measure of the number of cut edges arising and/or edge nodes arising;
- L denotes a first partition,
- R denotes a second partition,
- $C_{LR}$ denotes a number of couplings between the first partition and the second partition,
- |L| denotes a weighted number of elements which the first partition contains,
- |R| denotes a weighted number of elements which the second partition contains.

**Revendications**

**1.** Procédé assisté par ordinateur pour le partitionnement d'un circuit électrique,

selon lequel l'image du circuit électrique est reproduite sur un graphe, qui possède la même topologie que le circuit électrique,

selon lequel aux noeuds et/ou aux bords du graphe sont associées des valeurs de pondération, avec lesquelles est décrite la dépense requise de calcul pour la détermination de grandeurs électriques de description pour des éléments du circuit électrique, qui sont représentés par le noeud respectif et/ou par le bord respectif,

- selon lequel on applique aux éléments un procédé pour positionner les éléments du circuit électrique,
- selon lequel lors du procédé pour positionner les éléments, on minimise la longueur totale de couplages entre les éléments, en prenant en compte les valeurs de pondération associées aux noeuds et/ou aux bords,
- selon lequel pour le circuit électrique on détermine une mesure pour un nombre de bords découpés existants de partitions du circuit électrique lors du partitionnement, et
- selon lequel les éléments sont regroupés dans des partitions, en fonction de la mesure.

2. Procédé selon la revendication 1, selon lequel au début du procédé, on effectue un regroupement d'éléments du circuit électrique, pour lesquels il est respectivement établi que ces éléments sont associés en commun à une partition.

3. Procédé selon la revendication 2, selon lequel dans le cas du regroupement des éléments du circuit électrique, on utilise au moins l'une des prescriptions suivantes :

- on associe des éléments d'une source commandée, au moins un élément de commande et la source commandée, en commun à une partition,
- on associe, en commun à une partition des boucles de liaison dans le circuit électrique,
- il ne doit apparaître aucun court-circuit sous l'effet du partitionnement et/ou en raison d'une modélisation d'une interface.

4. Procédé selon l'une des revendications 1 à 3, selon lequel une valeur de pondération commune est associée à plusieurs noeuds et/ou bords du graphe.

5. Procédé selon l'une des revendications 1 à 4, selon lequel on forme l'image du graphe de la partition sur le circuit électrique, la partition comportant les éléments du circuit électrique conformément au partitionnement exécuté.

6. Procédé selon l'une des revendications 1 à 5,

- selon lequel plusieurs partitions sont formées au moyen de l'exécution multiple du procédé, et
- selon lequel les grandeurs électriques de description sont déterminées pour les éléments du circuit électrique pour chaque partition au moins une partie des partitions étant traitée en parallèle dans plusieurs calculateurs et/ou processeurs.

7. Procédé selon la revendication 6, selon lequel le traitement parallèle des partitions est commandé d'une manière centrale.

8. Procédé selon la revendication 7, selon lequel au moins une partie des partitions est commandée d'une manière centrale de telle sorte que tous les raccordements de la partition respective sont couplés uniquement à une unité centrale de commande et que par conséquent il se produit un transfert de données uniquement entre l'unité centrale de commande et au moins la partie des partitions.

9. Procédé selon la revendication 8, selon lequel à au moins une partie des raccordements de la partition respective est affectée en outre une source de tension, dont la valeur est prédéterminée par l'unité centrale de commande pendant la détermination des grandeurs électriques de description.

10. Procédé selon la revendication 9, selon lequel en outre une résistance est affectée à au moins une partie des raccordements de la partition respective.

11. Procédé selon l'une des revendications 1 à 10, selon lequel la mesure pour le nombre de bords découpés qui apparaissent et/ou le nombre de noeuds de bords qui apparaissent est formée respectivement selon la prescription suivante :

$$RC = \frac{C_{LR}}{|L| \cdot |R|},$$

avec

- RC désignant la mesure du nombre des bords découpés qui aparaissent et/ou des noeuds marginaux qui apparaissent,
- L désignant une première partition,
- R désignant une seconde partition,
- $C_{LR}$ désignant un nombre de couplage de la première partition avec la seconde partition,
- |L| désignant un nombre pondéré des éléments qui contient la première partition,
- |R| désignant un nombre pondéré des éléments que la seconde partition contient.

# FIG 1

Elektrische Schaltung liegt in einer
Schaltungsbeschreibungssprache vor

101

Abbildung der elektrischen Schaltung auf
einen Graphen

102

Zuordnen von Gewichtswerten Knoten und/
oder Kanten des Graphen

103

Durchführung eines Plazierungsverfahrens
auf den gewichteten Graphen, bei dem
eine Gesamtlänge der Kopplungen der
Elemente minimiert wird

104

Ermittlung eines Maßes für eine durch eine
Partitionierung enstehende Anzahl von
geschnittenen Knoten und/oder von
Randknoten jeweils einer Partition

105

Gruppierung der Elemente in Partitionen,
abhängig von dem Maß

106

L

# FIG 2